# EUROPEAN PATENT SPECIFICATION

(11) **EP 4 036 780 B1**
(45) Date of publication and mention of the grant of the patent: **14.10.2026**
(21) Application number: 21154071.1
(22) Date of filing: 28.01.2021
(51) Int. Cl.: G06F 30/20

(54) **ELECTRONIC CONTROL UNIT TIMING EMULATION**
TIMING-EMULATION EINER ELEKTRONISCHEN STEUEREINHEIT
ÉMULATION DE SYNCHRONISATION D'UNITÉ DE COMMANDE ÉLECTRONIQUE

(43) Date of publication of application: 03.08.2022
(73) Proprietor: Robert Bosch GmbH, 70442 Stuttgart (DE)
(72) Inventor: Raghupatruni, Indrasen, 71282 Hemmingen (DE); Sayler, Matthias, 74343 Sachsenheim (DE); See, Ole, 70376 Stuttgart (DE); Huber, Thomas, 71717 Beilstein (DE); Sambuddha, Karjee, 560078 Bengaluru (IN)

(56) References cited:
- US-A1- 2009 306 952
- JIE LIU ET AL: "Timed multitasking for real-time embedded software", IEEE SIGNAL PROCES SING MAGAZINE, IEEE SERVICE CENTER, PISCATAWAY, NJ, US, vol. 23, no. 1, 1 February 2003 (2003-02-01), pages 65 - 75, XP002381417, ISSN: 1053-5888

## Description

### TECHNICAL FIELD

This specification relates to a computer-implemented method for simulating the scheduling and execution of a plurality of model partitions of a software model by a timing controller, and an associated apparatus, computer program element, computer readable medium, and a vehicle Electronic Control Unit.

### BACKGROUND

As automotive systems continue to increase in complexity, owing, for example, to improved driver assistance systems, more complicated powertrains, and more modular control systems, there is an increase in system complexity. Verification of automotive systems comprising electronics, sensors, and processors may be performed, for example, using front-loading tests performed on prototype vehicles, or hardware in the loop (HiL) and software in the loop (SiL) to validate design decisions.

However, the design space of modern automotive systems is so large that methods of verification may still be improved.

### PRIOR ART

Jie Liu et al. "Timed multitasking for real-time embedded software", IEEE SIGNAL PROCESSING MAGAZINE, IEEE SERVICE CENTER, PISCATAWAY, NJ, US, vol. 23, no. 1, 1 February 2003 (2003-02-01), pages 65-75 discloses an event-triggered programming
model, timed multitasking (fM), that takes a time-centric approach to real-time programming but controls timing properties through deadlines and events rather than time triggers.

US 2009/306952 A1 discloses a physical unit simulator that, in anormal operation is allowed to speculatively perform high-speed continuous execution. Only when an actual input comes in, a speculative input and the actual input are compared with each other. Thereafter, in response to inconsistency between the inputs, the physical unit simulator is returned to a point closest to the point of the actual input and is allowed to execute a variable step module to reach the point of the actual input. Upon arrival at the point of the actual input, the simulator is shifted back to the highspeed continuous execution from there. Thus, a processing speed of the simulator can be significantly improved.

### FIGURE DESCRIPTION

**Fig. 1** schematically illustrates a method according to the first aspect.
**Fig. 2** schematically illustrates an apparatus according to the third aspect.
**Fig. 3** schematically illustrates a process for obtaining runtime measurements to provide a timing controller.
**Fig. 4** schematically illustrates a simulation setup incorporating a timing controller.
**Fig. 5a** schematically illustrates an example of a method for operating a timing controller.
**Fig. 5b** schematically illustrates an example of a method for operating an external scheduler.
**Fig. 6** schematically illustrates a timing model in relation to a simulation system.
**Fig. 7** schematically illustrates an example of a model partition arrangement.
**Fig. 8** schematically illustrates the output according to the example code of **Fig. 7****.**

### DETAILED DESCRIPTION

The development of virtual electronic control units (vECUs) for automotive use is a complicated process. During the development of vECUs, parts of the production software may be abstracted, removed, or "stubbed", in comparison to the software deployed in a genuine electronic control unit (ECU). Such abstraction is beneficial because it reduces the complexity of the software build in the development vECU. However, such abstraction (removal of base software in the vECU) may introduce uncertainties compared to a software deployment in a real electronic control unit (ECU), especially in relation to the timing in the virtual test environment (such as virtual hardware in the loop, HiL). Accordingly, it would be desirable to benefit from the reduction in complexity when abstracting less important modules of a vECU, but to remain confident that the timing of modules of the vECU remains accurate, even though a part of the production software has been abstracted, removed, or stubbed.

In particular, the "functional mock-up interface standard" FMI is an open standard for a simulation environment that defines an interface to exchange dynamic models using a combination of, for example, XML files, binaries, and C code. Examples of the present technique may provide an ECU using models defined by the FMI standard. However, this is not essential, and a model-based simulation environment may be provided as a dynamic link library (.dll) in Microsoft Windows (TM), or an object file in Linux (TM). Independently of the implementation platform, the present technique provides a vECU capable of timing accurate simulation.

A dynamic model can comprise a "scheduled execution interface" enabling individual model partitions (such as tasks of a control algorithm) to be called by a timing provider that acts as (and is referred to subsequently on this document) an external scheduler. The timing provider is responsible for tasks such as triggering execution of synchronous and asynchronous external events for all model partitions of a functional mock-up unit (FMU), advancing the overall simulation time and handling events (such as clock ticks) signalled by the FMUs. Scheduled execution of dynamic models in the SiL (software in the loop) environment has some limitations.

For example, when controlling the runtime behaviour and timing of a vECU as close to the target hardware as possible, the current tooling for vECU SiL does not support pre-emptive scheduling of tasks. As a result, all tasks are executed in a cooperative scheduling mode which reduces the scope of SiL testing. Therefore, the vECU in the SiL environment cannot be used to validate the runtime optimisation, calibration, and timing accurate functional behaviours. Furthermore, when simulating a vECU by multicore or parallel simulation, the simulation environment (such as a simulation environment supporting the FMI standard) forces a lack of access to internal states and partitions in the vECU, because the entire block works synchronously with micro-steps in sequential order. Providing a multicore simulation enables deterministic testing of data transmission implementations between model partitions which otherwise would not be possible via sequential execution.

According to a first aspect, there is provided a computer-implemented method for simulating the scheduling and execution of a plurality of model partitions of a software model by a timing controller, the method comprising:
- obtaining a timing model specifying, for a plurality of model partitions of a software model, an activation sequence of at least a first and a second model partition and a plurality of execution trigger times of the first and the second model partitions;
- receiving a master simulation clock; and
- triggering, using the timing controller, at least one external scheduler,
wherein the external scheduler activates at least the first and second model partitions of the software model according to the activation sequence defined by the timing model relative to the master clock simulation signal, and at an execution trigger time defined by the plurality of execution trigger times of the timing model.

In other words, a timing model may be observed from measurethose obtained from tests in the "BTF" format ("Best Trace Format").

Alternatively, the timing model be designed *a priori* according to the known performance of system components.

The timing model ensures that the activation sequence and trigger times of a plurality of model partitions are predictable, irrespective of any other alterations to a vECU SiL such as may potentially be caused by "stubbing", for example. According to a third aspect, there is provided an apparatus 20 for simulating a timing controller that schedules the execution of a plurality of model partitions of a software simulation, comprising:
- an input interface 22;
- a processor 24;
- a memory 26; and
- an output interface 28.

The input interface is configured to obtain a timing model specifying, for a plurality of model partitions of a software model, an activation sequence of at least a first and a second model partition and a plurality of execution trigger times of the first and the second model partitions, and to store the timing model in the memory.

The input interface is configured to receive a master simulation clock signal.

The processing unit is configured to trigger, using the timing controller, at least one external scheduler, wherein the external scheduler activates at least the first and second model partitions of the software model according to the activation sequence defined by the timing model, and at an execution trigger time defined by the plurality of execution trigger times of the timing model relative to the master clock.

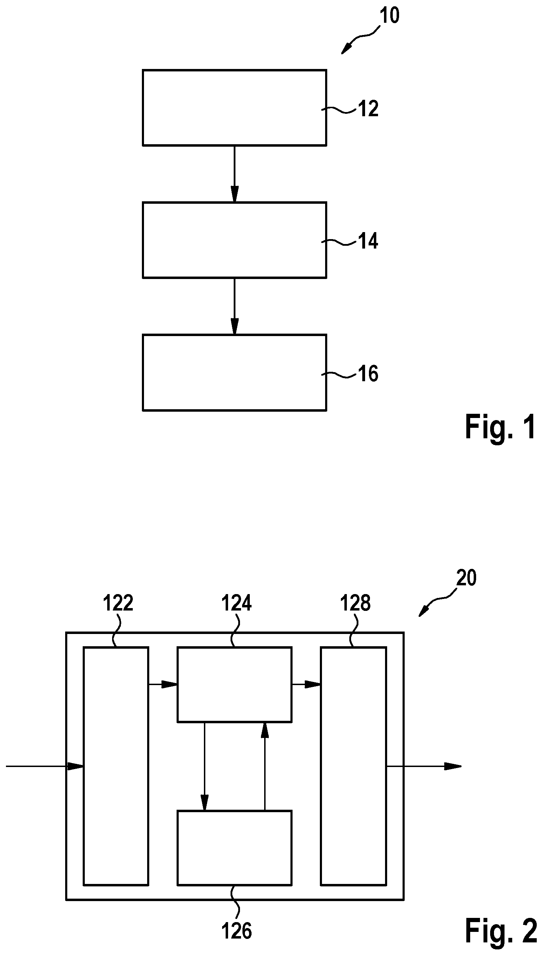

**Fig. 2** schematically illustrates an apparatus 20 according to the third aspect. In an example, the data processing apparatus 20 is a personal computer, server, cloud-based server, or embedded computer. It is not essential that the processing occurs on one physical processor. For example, it can divide the processing task across a plurality of processor cores on the same processor, or across a plurality of different processors, or virtual machines. The processor may be a Hadoop (TM) cluster, or provided on a cloud processing service. A portion of the processing may be performed on non-conventional processing hardware such as a field programmable gate array (FPGA), an application specific integrated circuit (ASIC), one or a plurality of graphics processors, application-specific processors for machine learning, and the like.

The memory 26, such as a volatile and/or non-volatile memory system of the apparatus 20 stores a computer program according to the fourth aspect that, when executed by the processor 24, causes the processor to execute the functionalities described by the computer-implemented methods according to the first and second aspects. According to an example, the input interface 22 and/or output interface 24 is one of a USB interface, an Ethernet interface, a WLAN interface, or other suitable hardware capable of enabling the input and output of data samples from the apparatus 20.

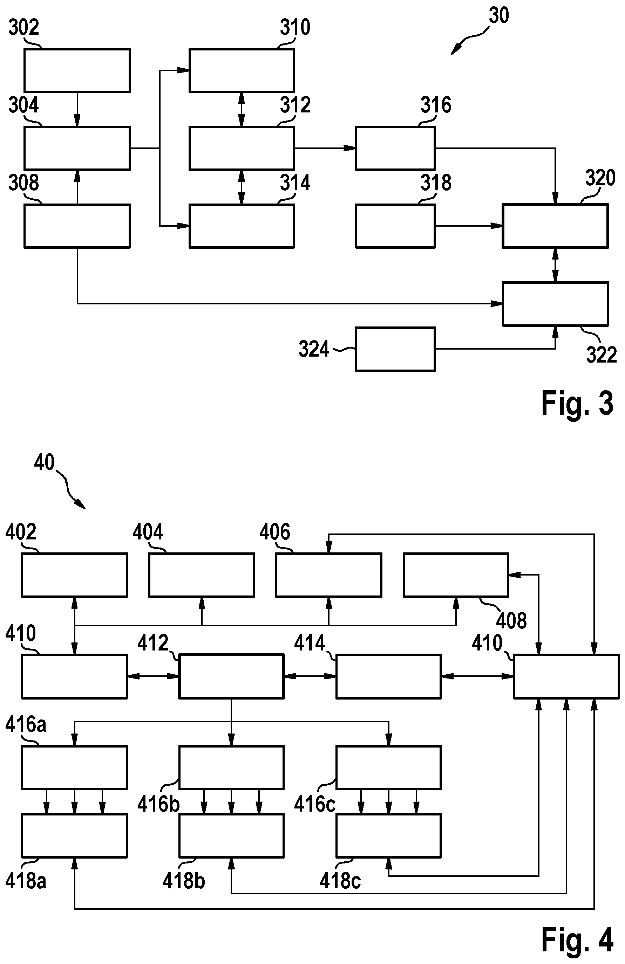

**Fig. 3** schematically illustrates a process for obtaining runtime measurements to provide a timing controller.

In particular, test scenarios 304 to extract timing properties are derived from at least a system architecture 302 of the simulated system (the system being simulated for functional verification, which may comprise, for example, one or more processors, sensors, communication networks, and actuators). Furthermore, timing properties may be derived from the overall software architecture 308. As many test scenarios may be provided as a test designer considers will give acceptable verification coverage. Once one or more test scenarios 304 have been derived, they are executed using either a hardware in the loop simulator 310, or a test vehicle 314, or both. Both the hardware in the loop simulator 310 and the test vehicle 314 may be interfaced to a runtime measurement tool 312. The runtime measurement tool 312 obtains one or more signals of interest from the hardware in the loop 310 and/or the test vehicle 314. In other words, the realistic behaviour of test signals in a defined test scenario 304 are obtained.

In an embodiment, the test signals are in the "BTF" format ("Best Trace Format" or "Better Trace Format".

In an example, a test scenario is an automotive test scenario, such as a driving cycle defined by the world harmonized light-duty vehicles test procedure (WLTP) or a high engine load condition (in the case of a combustion engine).

Therefore, according to the second aspect, the method for predefining a computer-implemented simulation method of a timing controller comprises:
- defining one or more automotive test scenarios of an automotive vehicle or subsystem thereof;
- obtaining a plurality of run-time timing characteristics, using a run-time measurement probe configured to observe software signals of an Electronic Control Unit and/or during the execution of the one or more automotive test scenarios;
- generating a timing model based on the observed software signals; and
- performing the steps of the method of the first aspects, or its embodiments.

An example of runtime measurements may be, for example, logical control signals measuring the time at which a brake pedal is depressed, the time at which a software interrupt in an ECU receives the signal from the brake pedal, and a latency before the ECU generates a command to a braking means, will appreciate that many other forms of runtime measurements may be obtained.

A Timing Control and Communication Module (TCCM, 320) is provided with, or programmed with, the runtime measurements 316. The TCCM 320 interfaces with an external scheduler 322 enabling the scheduling, in a simulation, of one or more virtual engine control units (vECUs). Optionally, the TCCM 320 may be provided with a hardware property configuration 318 defining the parameters of the system and software architecture used to obtain the runtime measurements. In an embodiment, realistic software artefacts 324 are be provided to the external scheduler to improve the accuracy and/or realism of the scheduling. Optionally, during the collection of the runtime measurements 316, the test scenarios 304 are be developed to obtain a range of output values. For example, the hardware in the loop 310 configuration is varied to collect one or more of a best-case, worst-case, and average execution timing.

In other words, Fig. 3 demonstrates a methodology that may be applied to generate timing models, and an external scheduler, from the previously known system and software architecture, as well as corresponding software artefacts such as an operating system scheduling scheme of the software runnables, an interrupt scheme, and task priorities for the individual control units.

The test scenarios are specifically intended to extract the timing properties of the system and its software runnables executed in the hardware in the loop, or test vehicle, and runtime measurements are extracted using runtime measurement tools. These runtime measurements, along with the hardware properties of the system and configuration of individual control units may be used to create a closed loop TCCM 320.

**Fig. 4** schematically illustrates a simulation setup incorporating a timing controller.

The simulation setup 40 comprises, for example, a driver model 402, an environment model 404, an actuator model 406, and a sensor model 408. The environment model 404 can, for example, incorporate a map around which an ego vehicle drives using computer intelligence. The ego vehicle reacts to objects in the simulated environment model 404 according to a driver model 402. As the ego vehicle is moves around the simulated environment model 404, the sensor model 408 outputs expected sensor signals from the combination of the driver model 402 and the environment model 404. In response to events occurring in the environment model 404, the driver model 402 may actuate one or more actuators represented in the actuator model 406. This activity is reported to the rest of the simulation via a virtual network 410.

In an embodiment, the second model partition is operably coupled to an actuator software model.

The simulation is synchronised to the simulation clock 410, from which the TCCM 412 according to aspects of the present specification obtains its master timing input signal.

The TCCM 412 is configured, in the simulated illustrated, to activate a plurality of external schedulers 416a, 416b, 416c. Each external scheduler is configured to schedule events occurring within one or more partitions of a plurality of corresponding vECUs 418a, 418b, 418c. The vECUs provide feedback via the virtual network and also simulate control of, for example, an actuator in the actuator model 406. Additionally, a fault injector 414 may deliberately cause the TCCM to provide a synthetic fault condition to at least one of the external schedulers 416a so that software verification over a series of test cases can be performed.

A skilled person will appreciate that many different simulation setups using vECUs may be provided without loss of generality.

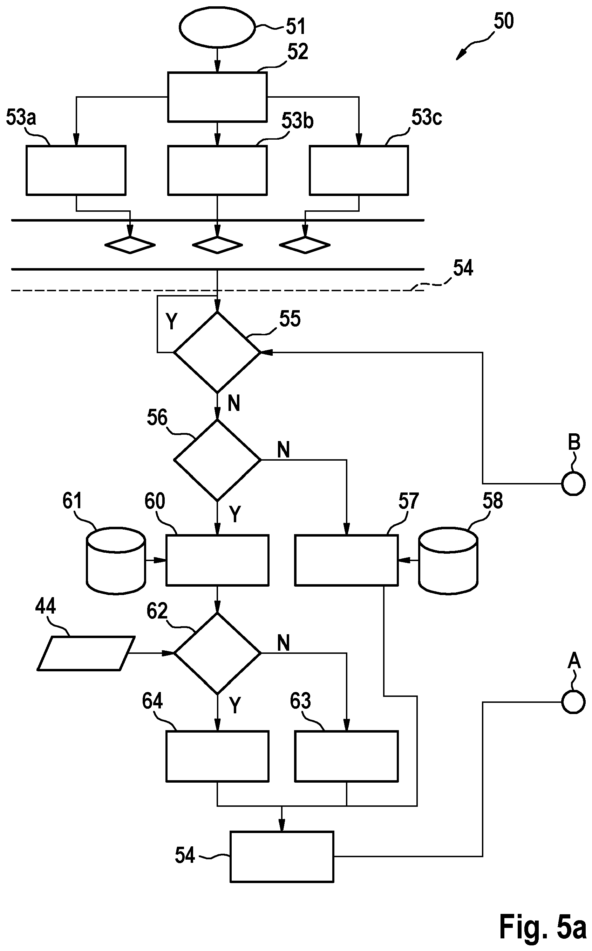

**Fig. 5a** schematically illustrates an example of a method for operating a timing and communication TCCM module.

In particular, the timing and communication module TCCM is initialized at a start step 51 and creates 52 at least one thread for executing an external scheduler 418a. In an embodiment, the TCCM creates 52 a plurality of parallel threads 53am 53b, 53c for each external scheduler.

The flowchart below the line 54 denotes the execution of one external scheduler at thread only, as an aid to clarity.

The TCCM initially checks 55 whether any active partitions are running in a vECU connected to a respective external scheduler modelled by a thread 53b. If yes, program flow does not continue and instead the thread continues to monitor for the presence of an active partition running in the vECU. If an active partition in the vECU ceases to be present, program flow advances to step 56. At this step, the TCCM checks whether, or not, a timing model is available, in, for example, an associated database, file store, or at another network location.

If a timing model is not available, the execution flow advances to step 57, at which point the TCCM reads a predefined activation order and execution time of vECU partitions of the vECU connected to the scheduler controlled by the present thread. Optionally, the predefined timing model 58 may be obtained from a database, or file store, for example.

In an embodiment, the timing model comprises a predefined timing model comprising a predefined activation sequence, and a plurality of predefined execution trigger times corresponding to the first and the second model partitions. In an embodiment, the timing model comprises a programmable activation sequence, wherein the trigger times are optionally varied based on a controlled randomization function or a random distribution function.

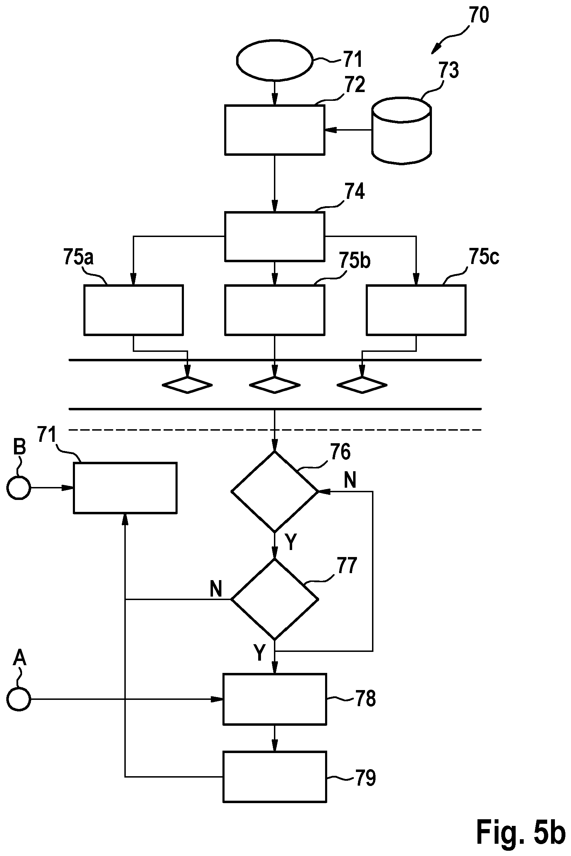

The execution flow then advances to step 59, at which point the trigger information such as the activation order and the execution time obtained at step 57 are transmitted (A) to the external scheduler (see Fig. 5b).

If, at step 56, a timing model is available to the TCCM, the program flow advances to step 60, at which point the order and dynamic execution time of the vECU partitions are read from a runtime timing model 61.

In this case, program flow advances to step 62 receiving an input from the fault injection engine 414. If no fault is injected, program flow advances to step 63, where the TCCM activates the next trigger as required by the runtime timing model without fault injection.

In an embodiment, the method comprises:
- receiving, from a fault injection engine of the timing controller, a command to inject a triggering fault into the simulation, wherein the triggering of the at least one external scheduler is adjusted according to the triggering fault received from the fault injection engine.

In an embodiment, the timing model comprises a runtime timing model comprising a partition activation sequence, and a plurality of execution trigger times corresponding to the first and the second model partitions, wherein the partition activation sequence and the plurality of execution trigger times are measured using a hardware in the loop test-rig.

If a fault injection by the fault injection engine 414 is detected, program flow advances to step 64 where the TCCM activates the next trigger, albeit with a fault injection. The outputs of either 63 or 64 are provided to step 59 as trigger information to the external scheduler 416.

A skilled person will appreciate that a similar set of steps are performed in parallel on parallel threads for the other external schedulers.

Feedback from the external scheduler is monitored by the TCCM at step 55, because step 55 of the TCCM external scheduler status feedback 71 from an external scheduler routine 70.

**Fig. 5b** schematically illustrates an example of a method for operating an external scheduler 70.

In particular, following a start step 71, the external scheduler program reads, at step 72, vECU information from a vECU model information datastore 73. The external scheduler 416a creates, at step 74, parallel threads for each model partition of a vECU 418a connected to the external scheduler 416a. Optionally, a simple vECU one model, in which case only one thread is required for scheduling. More often, a plurality of threads 75a-75c are provided and executed in parallel.

Program flow subsequently is illustrated for one model partition, but a skilled reader will appreciate that in a multithreaded processor, a plurality of threads may be executed in parallel.

At decision step 76, the external scheduler 416 for an active partition in a connected vECU. If an active partition is not present program flow continues to step 78, causing a partition in the corresponding vECU to be according to an execution time provided from step 59 of the TCCM method. Alternatively, if, at step 76, an active partition is present in the corresponding vECU, program flow advances to step 77 configured to check whether, or not, pre-emption is enabled. If pre-emption is enabled, to step 78. If pre-emption is not enabled, program flow returns to step 71, and appropriate feedback is provided to the TCCM.

In an embodiment, the method comprises pre-emptively scheduling the execution of a plurality of model partitions using the timing controller.

Accordingly, once it has been determined 78 to activate a model partition in a vECU with a given execution time, the partition is executed at step 79, with further feedback being provided to the TCCM.

In an embodiment, the method comprises:
- receiving, at the timing controller, a feedback signal from the at least one external scheduler defining whether the first model partition is active, or inactive; and
- activating the second model partition if the feedback signal indicates that the first model partition has become inactive, to thus provide closed-loop timing control to the first and second model partitions.

Accordingly, Figs. 5a and 5b illustrate the closed-loop timing environment between the TCCM and the external scheduler. The runtime timing model 61, in an embodiment, contains the activation order of partitions, the simulation execution time, and communication points of the target vECU based upon the methodology described above.

The timing model 58 may optionally contain simulation time, and communication points based upon the software architecture.

In an embodiment, the at least one vECU comprises vECU partition information based upon software artefacts.

In an embodiment, the TCCM 412 is configured to run parallel threads for each external scheduler 416.

In an embodiment, the TCCM 412 passes vECU partition trigger information to the external scheduler 416 based upon the current status of the external scheduler 416 at every macro simulation step.

Optionally, at least one external scheduler 416 may run parallel execution threads for each partition in a vECU.

Optionally, at least one external scheduler is responsible for activating at least one partition in a logically connected vECU based upon a trigger signal from the TCCM 412.

In an embodiment, the TCCM 412 is configured to be updated by one or more external schedulers 416 concerning the current state of each partition of the respective one or more vECUs. Optionally, the feedback signal forming the update may report "active", meaning that a partition is under execution, or "inactive", meaning that a partition execution has been completed.

In an embodiment, the method comprises:
- triggering, by the timing controller via the at least one external scheduler, a further model partition comprising an instruction set simulator configured to execute hardware specific object code. Therefore, important hardware routines may be simulated with increased realism, whilst enabling the remainder of the simulation to be conveniently based on a "Software in the Loop" approach.

In an embodiment, the software model is a virtual Electronic Control Unit. In an embodiment, the first model partition is coupled to an actuator model, optionally a brake pedal sensor model, a vehicle velocity model, or a steering wheel angle sensor model. In an embodiment a brake actuator model, an engine model, a steering system model, or a hybrid powertrain model.

A skilled person will appreciate that a far greater range of actuators and sensors may be controlled and simulated in a "software in the loop" and/or "hardware in the loop" test environment as detailed herein, and the foregoing examples are merely exemplary.

In an embodiment, the method comprises:
- executing the first model partition on a first processor of a multiprocessor system,
- executing the second model partition on a second processor of a multiprocessor system, and optionally comprising probing a plurality of messages between the first model partition and the second model partition to verify the software model.

In an embodiment, an execution trigger time in the plurality of execution trigger times represents at least one of a best case, average case, or worst case execution trigger time.

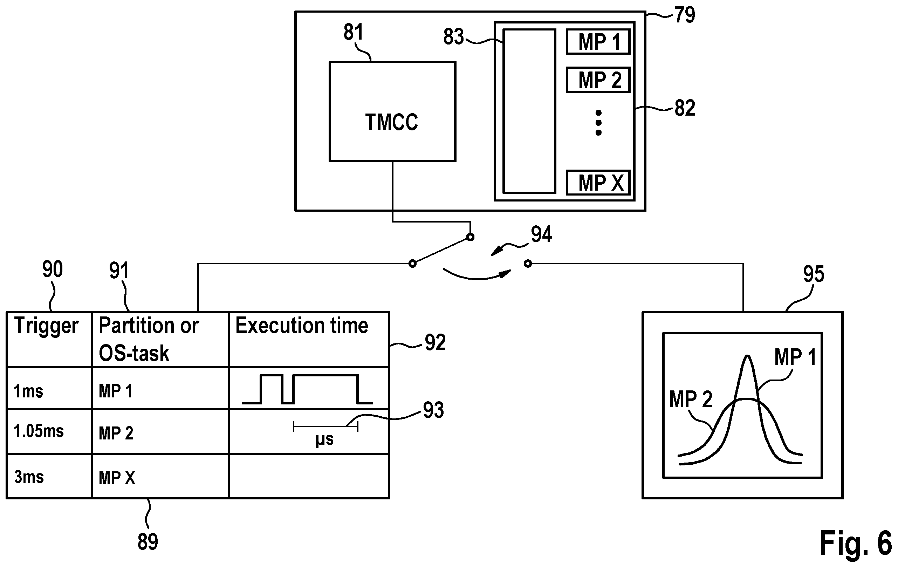

**Fig. 6** schematically illustrates a timing model in relation to a simulation system. For example, module 18 may, in the example, be a generic middleware instance used as a platform to implement a wrapper for the scheduled execution. According to the present technique, a timing controller TMCC interrupts the scheduler 83 of an FMU 82 in the conventional FMPy middleware.

In an embodiment, the TMCC 81 obtains a plurality of triggers and execution times from a preset scheduling database 89. The preset scheduling database 89 provides, for one or more model partitions, different time instants 90 as trigger times relative to a global simulation clock, for example, focused on one or more of the model partitions 91. The signal in column 92 defines each execution time, 93 for the corresponding model partition (measured in microseconds, for example). Accordingly, by reading the preset scheduling database 89 in order, a predefined order of model partition execution is provided.

In particular, partition MP1 defined a task that should occur at 10ms, partition MP2 defines a task that should occur at 20ms, and partition MP3 defines a task that should occur at 100m (with times referring to the tick of the master simulation clock, e.g. 1 ms in Fig. 6).

In another embodiment, the TMCC 81 may obtain input from a statistical trigger and execution signal generator 95. For example, an input signal defines a statistical distribution of partition trigger times relative to a master clock signal (variance and mean, for example). The input signal defines a statistical distribution (variance and mean, for example) distributions of partition execution times relative to a master clock signal. The logical switch 94 enables a selection of model partition trigger methods to be selected.

In an embodiment, the TMCC 81 is configured to obtain a trigger time of a first model partition MP1 from the preset scheduling database 89, and an execution time of the first model partition MP1 from the statistical trigger and execution signal generator 95.

In an embodiment, the TMCC 81 is configured to obtain a trigger time of a first model partition MP1 from the statistical trigger and execution signal generator 95, and an execution time of the first model partition MP1 from the preset scheduling database 89.

In an embodiment, the TMCC 81 is configured to obtain a trigger time of a first model partition MP1 and an execution time of the first model partition MP1 from the statistical trigger and execution signal generator 95.

In an embodiment, the TMCC 81 is configured to obtain a trigger time and an execution time of a first model partition MP1 from the preset scheduling database 89, and a trigger time and an execution time of second model partition MP2 from the statistical trigger and execution signal generator 95.

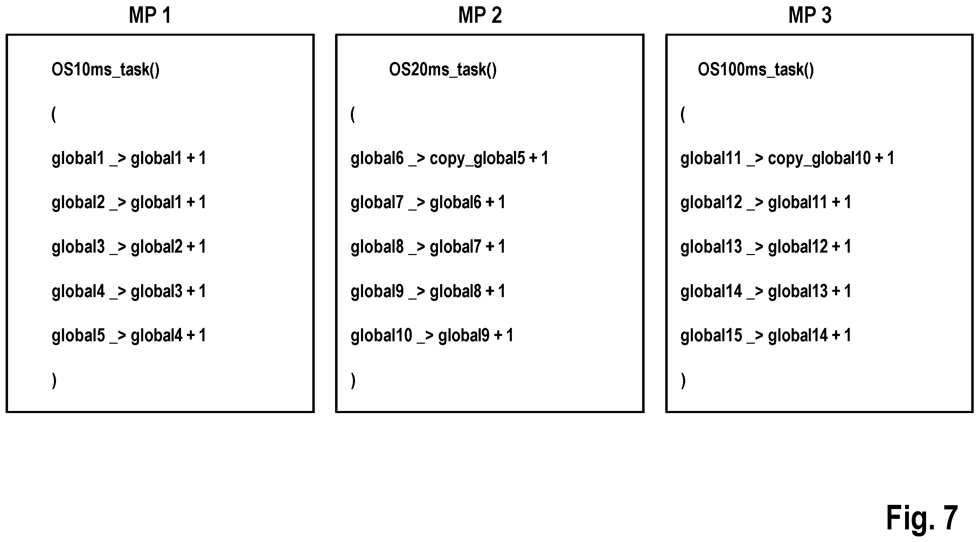

An example of pseudocode comprised in functions MP1, MP2, and MP3 comprise pseudocode is given in **Fig. 7****.**

**Fig. 7** schematically illustrates an example of a model partition arrangement. As shown in **Fig. 7****,** variables "global5" and "global10" are used in more than one Model Partition. Therefore, before the start of the respective model partition, value of these variables may be copied to holding variables "copy_global5" and "copy_global10", respectively.

During execution of the respective model partition, at necessary instances, only the copy variables are used for computation. This ensures that a parallel update of the original variable will not create a data inconsistency between model partitions. At the end of execution, when the corresponding output clock is deactivated, the copy variables are updated.

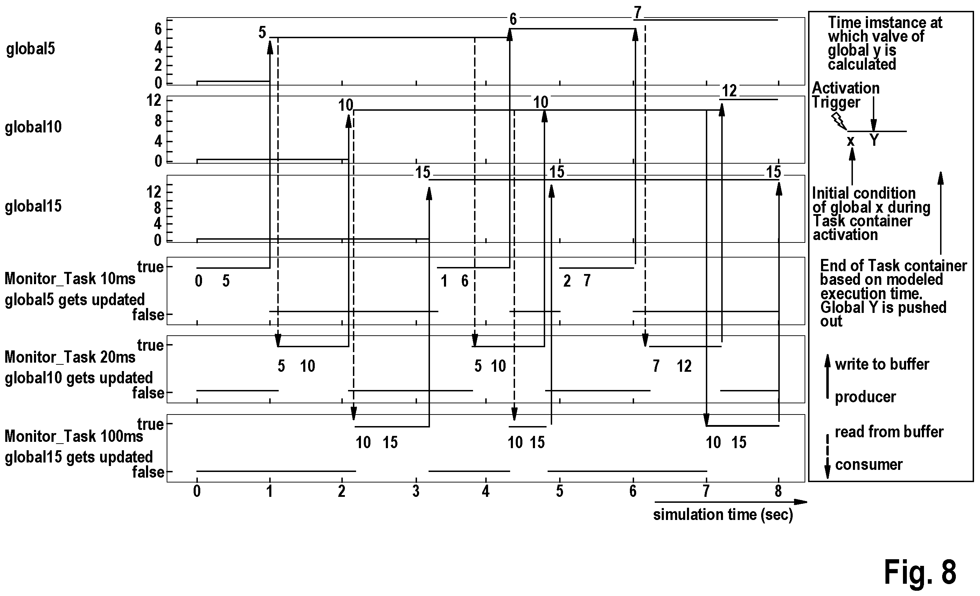

**Fig. 8** schematically illustrates an example output according to the example model code of **Fig. 7****.** Variables "monitor_task10ms", "monitor_task20ms", and "monitor_task100ms" represent the activation status of the model partitions OS10ms_task(), OS20ms_task(), OS100ms_task(), respectively. "global5", "global10", and "global15" are results of computations made in partitions OS10ms_task(), OS20ms_task(), and OS100ms_task(), respectively.

A fourth aspect provides computer program comprising machine-readable instructions which, when executed by a processor, is capable of carrying out either (i) the computer-implemented method according to the first aspect, or (ii) the computer-implemented method according to the second aspect, or (iii) the computer-implemented method according to the third aspect.

A fifth aspect provides a computer readable medium comprising at least one of the computer programs according to the fifth aspect.

A sixth aspect concerns a vehicle Electronic Control Unit comprising software simulated according to the method of the first aspect.

The examples provided in the drawings and described in the foregoing written description are intended for providing an understanding of the principles of this specification. No limitation to the scope of the appended claims is intended thereby. The present specification describes alterations and modifications to the illustrated examples. Only the preferred examples have been presented, and all changes, modifications, and further applications to these within the scope of the specification are desired to be protected.

## Claims

1. A computer-implemented method (10) for simulating the scheduling and execution of a plurality of model partitions of a software model by a timing controller, the method comprising:
- obtaining (12) a timing model specifying, for a plurality of model partitions of a software model, an activation sequence of at least a first and a second model partition and a plurality of execution trigger times of the first and the second model partitions,
wherein the timing model comprises a runtime timing model comprising a partition activation sequence, and a plurality of execution trigger times corresponding to the first and the second model partitions;
wherein the partition activation sequence and the plurality of execution trigger times are measured using a hardware in the loop test-rig;
- receiving (14) a master simulation clock; and
- triggering (16), using the timing controller, at least one external scheduler,
wherein the external scheduler activates at least the first and second model partitions of the software model according to the activation sequence defined by the
timing model relative to the master clock simulation signal, and at an execution trigger
time defined by the plurality of execution trigger times of the timing model.

2. The computer-implemented method (10) according to claim 1, further comprising:
- receiving, at the timing controller, a feedback signal from the at least one external scheduler defining whether the first model partition is active, or inactive; and
- activating the second model partition if the feedback signal indicates that the first model partition has become inactive, to thus provide closed-loop timing control to the first and second model partitions.

3. The computer-implemented method (10) according to one of claims 1 or 2,
- pre-emptively scheduling the execution of a plurality of model partitions using the timing controller.

4. The computer-implemented method (10) according to one of the preceding claims, further comprising:
- triggering, by the timing controller via the at least one external scheduler, a further model partition comprising an instruction set simulator configured to execute hardware specific object code.

5. The computer-implemented method (10) according to one of the preceding claims,
wherein the timing model comprises a predefined timing model comprising a predefined activation sequence, and a plurality of predefined execution trigger times
corresponding to the first and the second model partitions, and/or the timing model
comprises a programmable activation sequence,
wherein the trigger times are optionally varied based on a controlled randomization function or a random distribution function.

6. The computer-implemented method (10) according to claim 5,
- receiving, from a fault injection engine of the timing controller, a command to inject a triggering fault into the simulation, wherein the triggering of the at least one external scheduler is adjusted according to the triggering fault received from the fault injection engine.

7. The computer-implemented method (10) according to one of the preceding claims,
wherein the software model is a virtual Electronic Control Unit, and/or
wherein the first model partition is coupled to an actuator model, optionally a brake pedal sensor model, a vehicle velocity model, or a steering wheel angle sensor model; and/or
wherein the second model partition is operably coupled to an actuator software model, optionally a brake actuator model, an engine model, a steering system model, or a hybrid powertrain model.

8. The computer-implemented method (10) according to one of the preceding claims,
- executing the first model partition on a first processor of a multiprocessor system,
- executing the second model partition on a second processor of a multiprocessor system, and optionally comprising probing a plurality of messages between the first model partition and the second model partition to verify the software model.

9. The computer-implemented method (10) according to one of the preceding claims,
wherein an execution trigger time in the plurality of execution trigger times represents at least one of a best case, average case, or worst case execution trigger time.

10. A method for predefining a computer-implemented simulation method of a timing controller comprising:
- defining one or more automotive test scenarios of an automotive vehicle or subsystem thereof;
- obtaining a plurality of run-time timing characteristics, using a run-time measurement probe configured to observe software signals of an Electronic Control Unit and/or during the execution of the one or more automotive test scenarios;
- generating a timing model based on the observed software signals; and
- performing the steps of the method according to one of claims 1 to 9.

11. An apparatus (20) for simulating a timing controller that schedules the execution of a plurality of model partitions of a software simulation, comprising:
- an input interface (22);
- a processor (24);
- a memory (26); and
- an output interface (28);
wherein the input interface (22) is configured to obtain a timing model specifying, for a plurality of model partitions of a software model, an activation sequence of at least a first and a second model partition and a plurality of execution trigger times of the first and the second model partitions,
wherein the timing model comprises a runtime timing model comprising a partition activation sequence, and a plurality of execution trigger times corresponding to the first and the second model partitions;
wherein the partition activation sequence and the plurality of execution trigger times are measured using a hardware in the loop test-rig, wherein the processor (24) is configured to store the timing model in the memory;
wherein the input interface (22) is further configured to receive a master simulation clock signal; and
wherein the processor (24) is configured to trigger, using the timing controller, at least one external scheduler, wherein the external scheduler activates at least the first and second model partitions of the software model according to the activation sequence defined by the timing model, and at an execution trigger time defined by the plurality of execution trigger times of the timing model relative to the master clock.

12. A computer program comprising machine-readable instructions which, when executed by a processor, is capable of carrying out the computer-implemented method according to one of claims 1 to 10.

13. A computer readable medium comprising at least one of the computer programs according to claim 12.

## Patentansprüche

1. Computer-implementiertes Verfahren (10) zum Simulieren der Zeitplanung und Ausführung einer Mehrzahl von Modellunterteilungen eines Software-Modells durch eine Zeitvorgabesteuerung, wobei das Verfahren Folgendes umfasst:
- Erhalten (12) eines Zeitvorgabemodells, das für eine Mehrzahl von Modellunterteilungen eines Software-Modells eine Aktivierungssequenz von mindestens einer ersten und einer zweiten Modellunterteilung und eine Mehrzahl von Zeitpunkten der Ausführungsauslösung der ersten und der zweiten Modellunterteilung spezifiziert,
wobei das Zeitvorgabemodell ein Laufzeit-Zeitvorgabemodell umfasst, das eine Unterteilungsaktivierungssequenz und eine Mehrzahl von Zeitpunkten der Ausführungsauslösung, die der ersten und der zweiten Modellunterteilung entsprechen, umfasst;
wobei die Unterteilungsaktivierungssequenz und die Mehrzahl von Zeitpunkten der Ausführungsauslösung unter Verwendung eines Hardware-in-the-Loop-Prüfstands gemessen werden;
- Empfangen (14) eines Hauptsimulationstakts; und
- Auslösen (16) mindestens eines externen Zeitplaners unter Verwendung der Zeitgebungssteuerung, wobei der externe Zeitplaner mindestens die erste und die zweite Modellunterteilung des Software-Modells gemäß der Aktivierungssequenz aktiviert, die durch das Zeitvorgabemodell relativ zu dem Hauptsimulationssignal definiert wird, und zu einem Zeitpunkt der Ausführungsauslösung, der durch die Mehrzahl von Zeitpunkten der Ausführungsauslösung des Zeitvorgabemodells definiert wird.

2. Computer-implementiertes Verfahren (10) nach Anspruch 1, das ferner Folgendes umfasst:
- Empfangen eines Rückmeldungssignals von dem mindestens einen externen Zeitplaner an der Zeitvorgabesteuerung, das definiert, ob die erste Modellunterteilung aktiv oder inaktiv ist; und
- Aktivieren der zweiten Modellunterteilung, wenn das Rückmeldungssignal angibt, dass die erste Modellunterteilung inaktiv wurde, um somit eine Zeitvorgabesteuerung im geschlossenen Kreis für die erste und die zweite Modellunterteilung bereitzustellen.

3. Computer-implementiertes Verfahren (10) nach einem der Ansprüche 1 oder 2,
- präemptives Zeitplanen der Ausführung einer Mehrzahl von Modellunterteilungen unter Verwendung der Zeitvorgabesteuerung.

4. Computer-implementiertes Verfahren (10) nach einem der vorstehenden Ansprüche, das ferner Folgendes umfasst:
- Auslösen einer weiteren Modellunterteilung, die einen Anweisungssatzsimulator umfasst, der zum Ausführen von harware-spezifischem Objektcode konfiguriert ist, durch die Zeitvorgabesteuerung über den mindestens einen externen Zeitplaner.

5. Computer-implementiertes Verfahren (10) nach einem der vorstehenden Ansprüche,
wobei das Zeitvorgabemodell ein vordefiniertes Laufzeit-Zeitvorgabemodell umfasst, das eine vordefinierte Aktivierungssequenz und eine Mehrzahl von vordefinierten Zeitpunkten der Ausführungsauslösung, die der ersten und der zweiten Modellunterteilung entsprechen, umfasst, und/oder das Zeitvorgabemodell eine programmierbare Aktivierungssequenz umfasst,
wobei die Zeitpunkte der Auslösung optional basierend auf einer gesteuerten Randomisierungsfunktion oder einer Funktion der willkürlichen Verteilung variiert werden.

6. Computer-implementiertes Verfahren (10) nach Anspruch 5,
- Empfangen eines Befehls zum Injizieren eines auslösenden Fehlers in die Simulation von einer Fehlerinjektions-Engine, wobei das Auslösen des mindestens einen externen Zeitplaners gemäß dem auslösenden Fehler, der von der Fehlerinjektions-Engine empfangen wird, justiert wird.

7. Computer-implementiertes Verfahren (10) nach einem der vorstehenden Ansprüche,
wobei das Softwaremodell eine virtuelle elektronische Steuereinheit ist, und/oder
wobei die erste Modellunterteilung mit einem Stellgliedmodell gekoppelt ist, optional mit einem Bremspedalsensormodell, einem Fahrzeuggeschwindigkeitsmodell oder einem Lenkradwinkelsensormodell; und/oder
wobei die zweite Modellunterteilung funktionsfähig mit einem Stellglied-Software-Modell gekoppelt ist, optional mit einem Bremsstellgliedmodell, einem Motormodell, einem Lenksystemmodell oder einem Hybridantriebsmodell.

8. Computer-implementiertes Verfahren (10) nach einem der vorstehenden Ansprüche,
- Ausführen der ersten Modellunterteilung auf einem ersten Prozessor eines Mehrprozessorsystems,
- Ausführen der zweiten Modellunterteilung auf einem zweiten Prozessor eines Mehrprozessorsystems, und optional das Sondieren einer Mehrzahl von Nachrichten zwischen der ersten Modellunterteilung und der zweiten Modellunterteilung zwecks Verifizierens das Software-Modells umfassend.

9. Computer-implementiertes Verfahren (10) nach einem der vorstehenden Ansprüche,
wobei ein Zeitpunkt der Ausführungsauslösung in der Mehrzahl von Zeitpunkten der Ausführungsauslösung mindestens eines von einem Zeitpunkt der Ausführungsauslösung im besten Fall, im durchschnittlichen Fall oder im schlechtesten Fall darstellt.

10. Verfahren zum Vordefinieren eines computerimplementierten Simulationsverfahrens einer Zeitvorgabesteuerung, Folgendes umfassend:
- Definieren eines oder mehrerer Automobiltestszenarien eines Kraftfahrzeugs oder eines Teilsystem davon;
- Erhalten einer Mehrzahl von Laufzeit-Zeitvorgabeeigenschaften unter Verwendung einer Laufzeitmesssonde, die dazu ausgelegt ist, Software-Signale einer elektronischen Steuereinheit und/oder während der Ausführung des einen oder der mehreren Automobiltestszenarien zu beobachten;
- Generieren eines Zeitvorgabemodells basierend auf den beobachteten Software-Signalen; und
- Durchführen der Schritte des Verfahrens nach einem der Ansprüche 1 bis 9.

11. Vorrichtung (20) zum Simulieren einer Zeitvorgabesteuerung, welche die Ausführung einer Mehrzahl von Modellunterteilungen einer Software-Simulation zeitlich plant, Folgendes umfassend:
- eine Eingabeschnittstelle (22);
- einen Prozessor (24);
- einen Speicher (26); und
- eine Ausgabeschnittstelle (28);
wobei die Eingabeschnittstelle (22) dazu ausgelegt ist, ein Zeitvorgabemodell zu erhalten, das für eine Mehrzahl von Modellunterteilungen eines Software-Modells eine Aktivierungssequenz von mindestens einer ersten und einer zweiten Modellunterteilung und eine Mehrzahl von Zeitpunkten der Ausführungsauslösung der ersten und der zweiten Modellunterteilung spezifiziert, wobei das Zeitvorgabemodell ein Laufzeit-Zeitvorgabemodell umfasst, das eine Unterteilungsaktivierungssequenz und eine Mehrzahl von Zeitpunkten der Ausführungsauslösung, die der ersten und der zweiten Modellunterteilung entsprechen, umfasst;
wobei die Unterteilungsaktivierungssequenz und die Mehrzahl von Zeitpunkten der Ausführungsauslösung unter Verwendung eines Hardware-in-the-Loop-Prüfstands gemessen werden, wobei der Prozessor (24) dazu ausgelegt ist, das Zeitvorgabemodell in dem Speicher zu speichern;
wobei die Eingabeschnittstelle (22) ferner dazu ausgelegt ist, ein Hauptsimulationstaktsignal zu empfangen; und
wobei der Prozessor (24) dazu ausgelegt ist, unter Verwendung der Zeitvorgabesteuerung mindestens einen externen Zeitplaner auszulösen, wobei der externe Zeitplaner mindestens die erste und die zweite Modellunterteilung des Software-Modells gemäß der Aktivierungssequenz aktiviert, die durch das Zeitvorgabemodell definiert ist, und zu einem Zeitpunkt der Ausführungsauslösung, der durch die Mehrzahl von Zeitpunkten der Ausführungsauslösung des Zeitvorgabemodells relativ zu dem Haupttakt definiert ist.

12. Computerprogramm, das maschinenlesbare Anweisungen umfasst, die, wenn sie von einem Prozessor ausgeführt werden, fähig sind, das computerimplementierte Verfahren nach einem der Ansprüche 1 bis 10 auszuführen.

13. Computerlesbares Medium, das mindestens eines der Computerprogramme nach Anspruch 12 umfasst.

## Revendications

1. Procédé (10), mis en œuvre par ordinateur, de simulation de l'ordonnancement et de l'exécution d'une pluralité de partitions de modèle d'un modèle logiciel par un contrôleur de gestion temporelle, le procédé comprenant :
- l'obtention (12) d'un modèle de gestion temporelle spécifiant, pour une pluralité de partitions de modèle d'un modèle logiciel, une séquence d'activation d'au moins une première et une deuxième partition de modèle et une pluralité d'instants de déclenchement d'exécution de la première et de la deuxième partition de modèle,
le modèle de gestion temporelle comprenant un modèle de gestion temporelle à l'exécution comprenant une séquence d'activation de partitions, et une pluralité d'instants de déclenchement d'exécution correspondant à la première et à la deuxième partition de modèle ;
la séquence d'activation de partitions et la pluralité d'instants de déclenchement d'exécution étant mesurées à l'aide d'un banc d'essai de type Hardware-in-the-Loop ;
- la réception (14) d'une horloge maîtresse de simulation ; et
- le déclenchement (16), à l'aide du contrôleur de gestion temporelle, d'au moins un ordonnanceur externe, l'ordonnanceur externe activant au moins les première et deuxième partitions de modèle du modèle logiciel selon la séquence d'activation définie par le modèle de gestion temporelle par rapport au signal d'horloge maîtresse de simulation, et à un instant de déclenchement d'exécution défini par la pluralité d'instants de déclenchement d'exécution du modèle de gestion temporelle.

2. Procédé (10) mis en œuvre par ordinateur selon la revendication 1, comprenant en outre :
- la réception, au niveau du contrôleur de gestion temporelle, d'un signal de rétroaction depuis l'au moins un ordonnanceur externe définissant si la première partition de modèle est active ou inactive ; et
- l'activation de la deuxième partition de modèle si le signal de rétroaction indique que la première partition de modèle est devenue inactive, de manière à fournir ainsi une commande de gestion temporelle en boucle fermée aux première et deuxième partitions de modèle.

3. Procédé (10) mis en œuvre par ordinateur selon l'une des revendications 1 ou 2,
- l'ordonnancement préemptif de l'exécution d'une pluralité de partitions de modèle à l'aide du contrôleur de gestion temporelle.

4. Procédé (10) mis en œuvre par ordinateur selon l'une des revendications précédentes, comprenant en outre :
- le déclenchement, par le contrôleur de gestion temporelle via l'au moins un ordonnanceur externe, d'une partition de modèle supplémentaire comprenant un simulateur de jeu d'instructions configuré pour exécuter un code objet spécifique au matériel.

5. Procédé (10) mis en œuvre par ordinateur selon l'une des revendications précédentes,
dans lequel le modèle de gestion temporelle comprend un modèle de gestion temporelle prédéfini comprenant une séquence d'activation prédéfinie, et une pluralité d'instants de déclenchement d'exécution prédéfinis correspondant à la première et à la deuxième partition de modèle, et/ou le modèle de gestion temporelle comprend une séquence d'activation programmable,
dans lequel les instants de déclenchement font facultativement l'objet d'une variation sur la base d'une fonction de randomisation commandée ou d'une fonction de distribution aléatoire.

6. Procédé (10) mis en œuvre par ordinateur selon la revendication 5,
- la réception, depuis un moteur d'injection de fautes du contrôleur de gestion temporelle, d'un ordre d'injection d'une faute de déclenchement dans la simulation, le déclenchement de l'au moins un ordonnanceur externe étant ajusté selon la faute de déclenchement reçue depuis le moteur d'injection de fautes.

7. Procédé (10) mis en œuvre par ordinateur selon l'une des revendications précédentes,
dans lequel le modèle logiciel est une unité de commande électronique virtuelle, et/ou
dans lequel la première partition de modèle est couplée à un modèle d'actionneur, facultativement un modèle de capteur de pédale de frein, un modèle de vitesse de véhicule ou un modèle de capteur d'angle de volant ; et/ou
dans lequel la deuxième partition de modèle est couplée de manière fonctionnelle à un modèle logiciel d'actionneur, facultativement un modèle d'actionneur de frein, un modèle de moteur, un modèle de système de direction ou un modèle de groupe motopropulseur hybride.

8. Procédé (10) mis en œuvre par ordinateur selon l'une des revendications précédentes,
- l'exécution de la première partition de modèle sur un premier processeur d'un système multiprocesseur,
- l'exécution de la deuxième partition de modèle sur un deuxième processeur d'un système multiprocesseur, et comprenant facultativement le sondage d'une pluralité de messages entre la première partition de modèle et la deuxième partition de modèle afin de vérifier le modèle logiciel.

9. Procédé (10) mis en œuvre par ordinateur selon l'une des revendications précédentes,
dans lequel un instant de déclenchement d'exécution parmi la pluralité d'instants de déclenchement d'exécution représente un instant de déclenchement d'exécution pour au moins l'un des cas suivants : meilleur cas, cas moyen ou pire cas.

10. Procédé de prédéfinition d'un procédé de simulation mis en œuvre par ordinateur d'un contrôleur de gestion temporelle, comprenant :
- la définition d'un ou de plusieurs scénarios d'essai automobile d'un véhicule automobile ou d'un sous-système de celui-ci ;
- l'obtention d'une pluralité de caractéristiques de gestion temporelle à l'exécution, à l'aide d'une sonde de mesure à l'exécution configurée pour observer des signaux logiciels d'une unité de commande électronique et/ou pendant l'exécution du ou des scénarios d'essai automobile ;
- la génération d'un modèle de gestion temporelle sur la base des signaux logiciels observés ; et
- la réalisation des étapes du procédé selon l'une des revendications 1 à 9.

11. Appareil (20) de simulation d'un contrôleur de gestion temporelle qui ordonnance l'exécution d'une pluralité de partitions de modèle d'une simulation logicielle, comprenant :
- une interface d'entrée (22) ;
- un processeur (24) ;
- une mémoire (26) ; et
- une interface de sortie (28) ;
dans lequel l'interface d'entrée (22) est configurée pour obtenir un modèle de gestion temporelle spécifiant, pour une pluralité de partitions de modèle d'un modèle logiciel, une séquence d'activation d'au moins une première et une deuxième partition de modèle et une pluralité d'instants de déclenchement d'exécution de la première et de la deuxième partition de modèle,
le modèle de gestion temporelle comprenant un modèle de gestion temporelle à l'exécution comprenant une séquence d'activation de partitions, et une pluralité d'instants de déclenchement d'exécution correspondant à la première et à la deuxième partition de modèle ;
dans lequel la séquence d'activation de partitions et la pluralité d'instants de déclenchement d'exécution sont mesurées à l'aide d'un banc d'essai de type Hardware-in-the-Loop, le processeur (24) étant configuré pour stocker le modèle de gestion temporelle dans la mémoire ;
dans lequel l'interface d'entrée (22) est en outre configurée pour recevoir un signal d'horloge maîtresse de simulation ; et
dans lequel le processeur (24) est configuré pour déclencher, à l'aide du contrôleur de gestion temporelle, au moins un ordonnanceur externe, l'ordonnanceur externe activant au moins les première et deuxième partitions de modèle du modèle logiciel selon la séquence d'activation définie par le modèle de gestion temporelle, et à un instant de déclenchement d'exécution défini par la pluralité d'instants de déclenchement d'exécution du modèle de gestion temporelle par rapport à l'horloge maîtresse.

12. Programme d'ordinateur comprenant des instructions lisibles par machine qui, lorsqu'elles sont exécutées par un processeur, permettent de réaliser le procédé mis en œuvre par ordinateur selon l'une des revendications 1 à 10.

13. Support lisible par ordinateur comprenant au moins l'un des programmes d'ordinateur selon la revendication 12.
